# EUROPEAN PATENT SPECIFICATION

(11) **EP 4 151 390 B1**
(45) Date of publication and mention of the grant of the patent: **30.07.2025**
(21) Application number: 21198107.1
(22) Date of filing: 21.09.2021
(51) Int. Cl.: B29C 51/14, B29L 31/34, H05K 3/00, H05K 13/00, H05K 1/02, B29C 51/30

(54) **METHOD FOR MANUFACTURING A NON-FLAT DEVICE BY DEFORMATION OF A FLAT DEVICE LAMINATE**
VERFAHREN ZUR HERSTELLUNG EINER NICHT FLACHEN VORRICHTUNG DURCH VERFORMUNG EINES FLACHEN VORRICHTUNGSLAMINATS
PROCÉDÉ DE FABRICATION D'UN DISPOSITIF NON PLAT PAR LA DÉFORMATION D'UN STRATIFIÉ DE DISPOSITIF PLAT

(43) Date of publication of application: 22.03.2023
(73) Proprietor: Imec VZW, 3001 Leuven (BE); Universiteit Gent, 9000 Gent (BE)
(72) Inventor: Madadnia, Behnam, Gent (BE); Vanfleteren, Jan, Gent (BE); Bossuyt, Frederick, Gent (BE)
(74) Representative: AWA Sweden AB

(56) References cited:
- EP-A1- 2 335 905
- WO-A1-2015/035970
- WO-A1-2018/099648
- US-A1- 2020 029 440
- US-B1- 11 039 531

## Description

### Technical field

The present inventive concept relates to a method for manufacturing a non-flat device by deformation of a flat device laminate.

### Background

In the prior art, methods for manufacturing non-flat electronics and circuits are known. For example, using printed circuit board (PCB) based techniques semi-rigid electronic circuits having a non-flat shape may be fabricated by interconnecting flat rigid assembled boards using flexible circuitry. Such techniques may be used to manufacture arbitrarily shaped circuits, but has limitations in terms of shapes that can be realized.

Another approach based on PCB technology is disclosed by Vanfleteren et. al in "A new technology for rigid 3D free-form electronics based on the thermoplastic deformation of flat standard PCB type circuits" (12th International Congress MID, 2016). The approach comprises the steps of encapsulating stretchable interconnects in thermoplastic polymer, and thermoforming the polymer into the shape of a semi-sphere such that the embedded interconnects are stretched. Due to the stretchable nature of the interconnects it may be challenging to control the final position of the electric components in a repeatable manner.

In WO2018054623A1, a method for manufacturing non-flat devices comprising elements such as electronic components and mechanical interconnects by thermoforming a flat device is disclosed. Designing the layout of the flat device includes inserting mechanical interconnections between pairs of elements to unambiguously define the position of the elements on a surface of the non-flat device, thus leaving zero or less than zero degrees of freedom for the location of the components. Based on the layout of a flat device thus obtained, the flat device is manufactured and next transformed into the shape-retaining non-flat device by means of a thermoforming process, thereby accurately and reproducibly positioning the elements at a predetermined location on a surface of the non-flat device. This approach hence relies on designing the layout of the flat device such that forces originating from the flow of thermoformable material and the mechanical interconnections connected to each element at the end of the thermoforming process reach an equilibrium. Although this approach may enable precise control over the final positions of the circuit elements the design process of the flat device laminate may be challenging due to a required calculation of interconnect parameters relating to the force balance during deformation.

WO 2018/099648 A1 relates to a method for designing a pattern of a stress relief layer for a flat device to be transformed into a shape-retaining non-flat device by deformation of the flat device. The flat device (and thus also the non-flat device) may comprise at least two components and at least one electrical interconnection between two components.

US 11 039 531 B1 discloses an In-Mold Electronics (IME) device and method of manufacturing the IME device introduce a stretchable substrate laminated to a thermoplastic layer. The stretchable substrate has a screen printable surface for receiving printed conductive interconnects.

US 2020/029440 A1 provides methods for manufacturing shape-retaining non-flat devices comprising components integrated on a device surface, the non-flat devices being made by deformation of a flat device.

EP2335905 A1 discloses method involving introducing a film piece resting on a conveying device into a heating zone. A heated film piece is introduced into a deformation zone and subjected with a fluid pressure medium. The heated film piece is isostatically formed to a desired thermoformed part. Film areas of the film piece are strongly heated before deformation.

WO 2015/035970 A1 relates to a method and a thermoforming or joining system for embedding an embedding element in a product.

### Summary

In view of the above, it is an objective of the present inventive concept to provide a method for manufacturing a non-flat device by deformation of a flat device laminate, which facilitates an accurate and reproducible positioning of circuit elements in the non-flat device. It is further an objective to achieve this aim without the need for complex and time-consuming calculations or simulations during design. Further and alternative objectives may be understood from the following.

According to an aspect of the present inventive concept there is provided a method for manufacturing a shape-retaining non-flat device, comprising:
providing a flat device laminate comprising:
   a first layer of thermoformable material;
   a carrier layer having:
      a first portion arranged to extend along a periphery of a device region of the flat device laminate in which the shape-retaining non-flat device is to be formed, wherein the first portion defines a frame enclosing an opening in the carrier layer; and
      a second portion protruding from the first portion into the opening in the device region to define a free end in the device region;
   conductive traces arranged at least on the second portion of the carrier layer; and
   a circuit element arranged at the free end of the second portion and electrically connected to the conductive traces;
deforming the device region of the flat device laminate into the shape-retaining non-flat device by thermoforming the flat device laminate, wherein the carrier layer is non-stretchable such that the length and shape of the conductive traces remain unchanged after the step of deforming, and the respective shortest distance, along the second portion of the carrier layer, between the circuit element and the first portion, prior to and after the step of deforming the flat device laminate, are equal.

It is a benefit of the present inventive concept, that there is no uncertainty in the length of the second portion of the carrier layer after forming the non-flat device, as it is equal to the length of the second portion of the carrier layer prior to the step of deforming the flat device laminate. Accordingly, the length of the second portion may remain constant prior to and after the step of deforming the flat device laminate as instead of being stretched by the flow of thermoformable material during the thermoforming, the thermoformable material may flow along the non-stretchable carrier layer. This facilitates an accurate and reproducible positioning of the circuit element in the non-flat device.

A further advantage associated with the non-stretchable design of the carrier layer is that the length and shape of the conductive traces arranged thereon may remain unchanged after the thermoforming, thus mitigating a variability in resistance of the conductive traces.

Hence, the length of the carrier layer and the electrical resistance of the conductive traces in the non-flat device may be controlled precisely. This implies that the method enables accuracy and repeatability in the sense that when repeated, the method is able to consistently produce the same accurate results.

In view of the above, the method facilitates correctly predicting the final position of the circuit element in the non-flat device. Thus, the method may simplify a design process of the provided flat device laminate, reducing the need for estimations or simulations of parameters relating to the non-flat device. This is beneficial in comparison to the use of an intrinsically stretchable carrier layer or a carrier layer fabricated in a stretchable pattern, where the stretchable carrier layers dimensions after the step of deforming may vary and are complex to determine. In order to determine the relationship between the distance between the circuit element and the first portion, prior to and after the step of deforming the flat device laminate in such a case, one would need to rely on estimates or simulations, taking many parameters and uncertainties into account.

According to some embodiments, the flat device laminate may further comprise a second layer of thermoformable material and the carrier layer, the conductive traces and the circuit element may be embedded between the first and second layer.

Thereby, the carrier layer, the conductive traces, and the circuit elements may be protected from exposure by the layers of thermoformable material. They may be isolated, and shielded from for instance moist or dust.

According to some embodiments, the second portion may be adapted to extend along a sidewall of the shape-retaining non-flat device after the thermoforming.

Thereby, the second portion may provide structural support to the sidewall of the non-flat device, thus contributing to the mechanical stability of the non-flat device.

According to some embodiments, the first portion may extend along the entire periphery of the device region of the flat device laminate to define a frame enclosing the device region.

Thereby the first portion may define a structural support along the device region in the non-flat device, thus contributing to the mechanical stability of the non-flat device.

According to some embodiments, the step of deforming the flat device laminate may comprise aligning the device region of the flat device laminate with a mold such that the second portion is positioned over an opening in the mold and the first portion extends along a periphery of the opening of the mold. More specifically, the step of deforming the flat device laminate may comprise first aligning the device region of the flat device laminate with the mold and thereafter deforming the flat device laminate by thermoforming.

By aligning the flat device laminate with a mold in this manner, a predictable and reproducible shaping of the flat device laminate into the non-flat device during the step of deforming is allowed.

The thermoformable material of the first (and second) layer(s) may be allowed to expand and line the inside of the mold (e.g. completely) and thereby obtain the non-flat shape. The first portion of the carrier layer may remain undeformed, extending along the opening of the mold. The second portion of the carrier layer may, due to its non-stretchable properties, be deformed by bending to follow the shape of the mold without being elongated or shortened, thus resulting in an exact and predictable position of the free end within the device region of the non-flat device.

According to some embodiments, the non-flat device may have a shape of a developable surface, a semi-sphere, a cylinder, a truncated pyramidical or a conical shape. The shapes listed facilitates thermoforming from a flat device laminate.

According to some embodiments, the second portion of the carrier layer of the flat device laminate may extend past a centerline of the opening of the mold by a distance such that the free end of the second portion may be positioned at a bottom of the mold after the step of deforming.

Thereby, a circuit element arranged at / supported by the free end may be positioned at a bottom surface of the non-flat device, e.g. at a central position of the bottom surface.

The circuit element may alternatively be arranged at an area of the second portion excluding the free end.

The flat device laminate may comprise more than one circuit element, distributed on the second portion.

As the non-stretchable carrier layer leaves only one possible spatial configuration for the circuit elements relative to each other, manufacturing of a non-flat device comprising more than one circuit element with accurate, predictable, and reproducible positioning of the circuit elements is facilitated.

According to some embodiments, the circuit element may comprise one or more discrete electrical/electronic components, electrically connected to the conductive traces. Additionally or alternatively, the circuit element may comprise one or more electrical components integrally formed with the conductive traces. Examples of discrete electrical components include typical active and passive circuit components like resistors, capacitors, inductors and transistors, as well as optical or opto-electrical components (e.g. photonic components), and sensors. Examples of integrally formed electrical components include capacitive and/or inductive components, e.g. antenna elements.

According to some embodiments, the circuit element may be or comprise a light emitting diode.

According to some embodiments, the circuit element may comprise two or more electrical components interconnected to form a sub-circuit electrically connected to the conductive traces. The circuit element may e.g. comprise a PCB supporting the two or more electrical components, arranged on the second portion, and electrically connected to the conductive traces. The two or more electrical components may be selected from any of the aforementioned examples of electrical components.

According to some embodiments, the flat device laminate may comprise a plurality of device regions and the carrier layer may comprise a plurality of first portions and a plurality of second portions, wherein each first portion may be arranged to extend along a periphery of a respective device region and each second portion may protrude from a respective first portion into a respective device region to define a free end,
and wherein the step of deforming may comprise deforming the plurality of device regions of the flat device laminate into a respective shape-retaining non-flat device by thermoforming.

Thereby parallel processing of a plurality of device regions may be facilitated, making the method more time- and cost-effective.

According to some embodiments, each of the device regions may be deformed simultaneously.

According to some embodiments, the method may further comprise, after the step of deforming, cutting away non device regions of the flat device laminate.

Thereby a plurality of individual devices may be produced from one flat device laminate, making the method more time- and cost effective.

### Brief description of the drawings

The above, as well as additional objects, features, and advantages of the present inventive concept, will be better understood through the following illustrative and non-limiting detailed description, with reference to the appended drawings. In the drawings like reference numerals will be used for like elements unless stated otherwise.
Fig. 1 is a flow chart of a method for manufacturing a non-flat device by deformation of a flat device laminate.
Fig. 2 is a flat device laminate.
Fig. 3 is a cross section of the flat device laminate.
Fig. 4 is a shape-retaining non-flat device.
Fig. 5a-b are perspective views of a device area of the shape-retaining non-flat device.
Fig. 6 is a perspective view of a mold.

### Detailed description

As disclosed herein there is provided a method for manufacturing a shape-retaining non-flat device from a flat device laminate. As used herein, the term" shape-retaining" is used to refer to that the non-flat device is ensured to retain its intended shape in absence of external forces. According to the method, the flat device laminate comprises a device region which is deformed into the shape-retaining non-flat device by thermoforming. The flat device laminate comprises a carrier layer having a first portion arranged to extend along a periphery of the device region of the flat device laminate in which the shape-retaining non-flat device is to be formed, and a second portion protruding from the first portion into the device region to define a free end. The carrier layer is non-stretchable such that the respective shortest distance, along a second portion of the carrier layer, between the circuit element and the first portion, prior to and after the step of deforming the flat device laminate, are equal. As used herein, the term "non-stretchable" with reference to the carrier layer should accordingly be understood as the carrier layer not being able to be stretched, expanded, or compressed during the thermoforming, but instead being mechanically stable and keeping the same length during and after the step of thermoforming is applied.

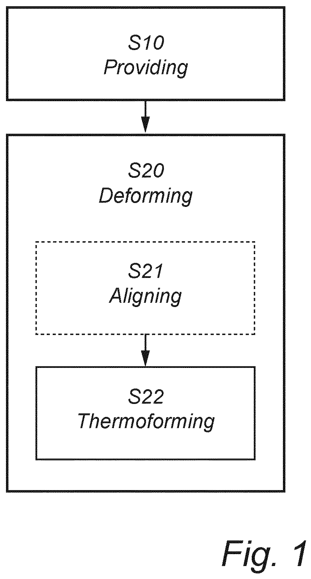

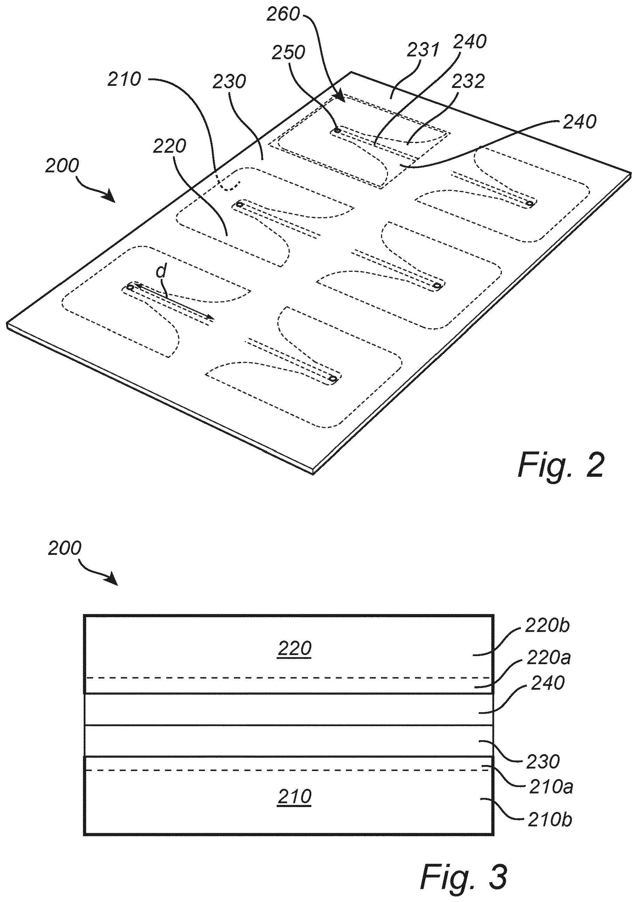

Referring now to the flow chart of Fig. 1 in conjunction with figures 2-6, embodiments of a method for manufacturing a non-flat device by deformation of a flat device laminate will now be described. In the following, the method will be described in relation to forming a non-flat device of a shape and design suitable for use e.g. as a luminaire in an indoor or outdoor lighting application. It is however to be understood that this merely represents an example and that the method has a general applicability in terms of product design and application. Non-flat devices formed by the method may for instance be suitable for use as capacitive touch sensors on curved surfaces in home appliances or automotive interior.

The method comprises a step of providing S10 a flat device laminate 200. The flat device laminate 200 according to an embodiment is illustrated in Fig. 2 and a cross section thereof is illustrated in Fig. 3. The flat device laminate 200 comprises a carrier layer 230. Conductive traces 240 and a circuit element 250 are arranged on the carrier layer 230. The flat device laminate 200 further comprises a first and second layer 210, 220 of thermoformable material arranged on opposite sides of the carrier layer 230 to embed the carrier layer. The thermoformable material of the first and second layers 210, 220 may be provided as a single material or a stack of at least two materials, as indicated by dashed lines in Fig. 3. If the thermoformable material is provided as a single material, it may comprise TPU. If the thermoformable material is provided as a stack, it may comprise an adhesive material 210a, 220a and a structural material 210b, 220b. The adhesive material 210a, 220a may be arranged closest to the carrier layer 230 and may comprise a polymer such as TPU. The structural material 210b, 220b may be arranged on the side of the adhesive material 210a, 220a, opposite to the carrier layer 230 and may comprise a polymer such as polycarbonate, PETG, PP or TPU, or another conventional thermoformable material suitable for the present application. The thermoformable material may be selected with regard to the temperature during the step of deforming such that the material does not melt during thermoforming. The first layer 210 and the second layer 220 may for example each have a thickness in the range of 100 µm to a few mm.

It should be realized that although the illustrated embodiment comprises a first and second layer 210, 220 of thermoformable material, the flat device laminate 200 may alternatively comprise a single layer of thermoformable material, e.g. corresponding to e.g. the first layer 210 which is illustrated as the bottom layer in Fig. 3.

Further, the flat device laminate 200 may comprise multiple layers of thermoformable material and multiple conductive traces 240 and circuit elements 250 arranged on multiple carrier layers 230. As an example (not illustrated), the flat device laminate 200 may comprise a first and second layer 210, 220 of thermoformable material, embedding a first carrier layer 230 with conductive traces 240 and a circuit element 250 arranged thereon. The flat device laminate 200 may on top of the second layer 220 comprise a further carrier layer 230 with conductive traces 240 and a circuit element 250 arranged thereon, and a top of that a third layer of thermoformable material. Further layers of carrier 230, conductive traces 240, circuit element 250 and thermoformable material may be added on top.

The carrier layer 230 has a first portion 231 arranged to extend along a periphery of a device region 260 of the flat device laminate 200. The device region 260 denotes a region in which the shape-retaining non-flat device 100 is to be formed. The carrier layer 230 further has a second portion 232 protruding from the first portion 231 into the device region 260 to define a free end therein. The second portion 232 may as shown be provided in a narrowing shape, having a widest portion where it protrudes from the first portion 231, and a most narrow portion at the free end. Other shapes of the second portion 232 are however also possible, such as a second portion 232 having the same width along its entire length. The second portion 232 may have a ratio between the narrowest width and the distance between the first portion 231 and the free end of at least 1/10.

As may be appreciated from the following, the second portion 232 may extend along a sidewall of the non-flat device 100 after the thermoforming S22.

The first portion 231 may as shown extend along the entire periphery of the device region 260 of the flat device laminate 200 to define a frame enclosing the device region 260. In other words, the first portion 231 defines a frame enclosing an opening or cut-out in the carrier layer 230, wherein the second portion 232 protrudes from the first portion / frame 231 into the opening to define a free end therein.

The carrier layer 230 may comprise a polymer such as Polyimide, PEN, or PET. The carrier layer 230 may comprise other materials, or a combination of different materials. The carrier layer 230 may have a thickness in the range of 5 µm to 125 µm, or in the range of 25 µm to 50 µm.

The conductive traces 240 (in Fig. 2, 4, 5a-b schematically indicated by pairs of dashed lines) are arranged on the carrier layer 230, more specifically on the second portion 232. The conductive traces 240 may as shown extend from the first portion 231 of the carrier layer, along the second portion 232, and to the circuit element 250. Although not shown in Fig. 2, the conductive traces 230 may further extend along the first portion 231, e.g. to form conductive terminals or leads of the non-flat device 100 for connection with peripheral circuitry such as driving circuitry for the circuit element 250.

The conductive traces 240 may as shown be adapted to extend between the circuit element 250 and the first portion 231 in two parallel segments being separate from each other. The method is however not limited to the particular layout illustrated in Figs. 2, 4 and 5a-b but is generally applicable to form other layouts of the conductive traces 240.

The conductive traces 240 may be attached or adhered to the carrier layer 230. The conductive traces 240 may comprise a metal such as silver or copper, an alloy comprising any thereof, or other metals suitable for the present application. The conductive traces 240 may comprise a conductive ink material and/or a plated material and/or patterned material from a metal sheet. The material may be laminated on the carrier layer 230 or deposited through electroplating, vapor deposition under vacuum, sputter deposition or other techniques. The conductive traces 240 may be etched into desired dimensions. The conductive traces 240 may comprise copper. The conductive traces 240 may have a thickness in the range of a few micrometers to 70 µm, or in the range of 18 µm to 35 µm.

As may be appreciated from the above, the view of the flat device laminate 200 in Fig. 3 represents the cross-section along a portion of the laminate 200 comprising the first and second layers 210, 220, the carrier layer 230 and conductive traces 240. However, as may be seen e.g. in Fig. 2 the laminate 200 may further comprises portions including the first and second layers 210, 220 and the carrier layer 230 but not conductive traces 240, and portions including the first and second layers 210, 220 but neither the carrier layer 230 nor conductive traces 240.

In the illustrated embodiment, the circuit element 250 of the flat device laminate 200 is provided in the form of an LED. The LED 250 is arranged on the second portion 232 and electrically connected to the conductive traces 240. Specifically, an anode of the LED 250 may be connected to one segment of the conductive traces 240, and a cathode of the LED 250 may be connected to another segment of the conductive traces 240.

The LED 250 (or more generally circuit element 250) may as illustrated in Figs. 2, 4, 5a-b be arranged at the free end of the second portion 232 such that the LED 250 (circuit element 250) becomes positioned at a bottom surface of the non-flat device 100. The LED 250 may as shown be positioned at an approximately centered position of the bottom surface of the non-flat device 100, however an off-center position is also possible. However, also other positions of the LED 250 in the non-flat device 100 are possible, such as along a sidewall of the non-flat device.

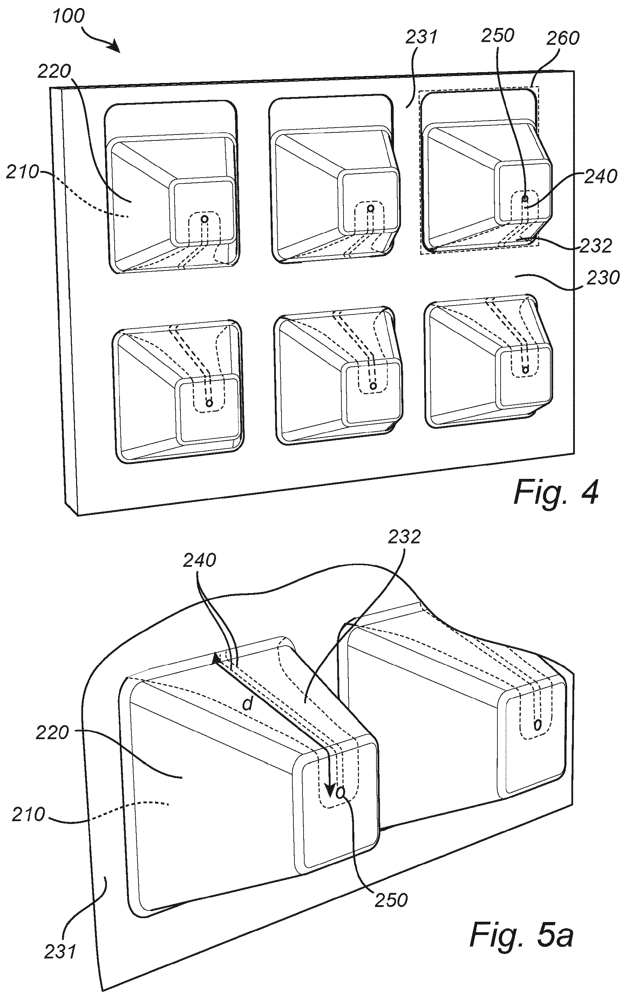

The non-flat device 100 is illustrated in Fig. 4 and Figs. 5a-b is provided in the shape of a truncated pyramid. The LED 250 may as shown be positioned at an approximately centered position of a bottom surface of the truncated pyramid, however an off-center position is also possible. By the non-flat device 100 being provided with a LED 250 at a bottom surface of a truncated pyramid, a high amount of forward emission from the LED 250 is allowed, facilitating a high level of light output from the non-flat device.

Alternatively, other positionings of the LED 250 in the non-flat device 100 are possible, such as along a sidewall of the non-flat device.

Alternatively to being provided in the form of a LED, the circuit element 250 may be another type of discrete electrical component, such as resistor, transistor, capacitor, or other types of diodes. The circuit element 250 may be an optical component, an opto-electronic component and/or a photonic component. The circuit element 250 may be a sensor, e.g. a capacitive sensor. Alternatively, the circuit element 250 may be an antenna element integrally formed with the conductive traces 240.

The circuit element 250 may comprise a plurality of components. The circuit element 250 may for instance be a PCB or PCB module comprising multiple electrical components, e.g. a PCB comprising an LED and a driver circuit, or some other sub-circuit suitable for the intended application.

The method is not limited to a pyramidical shape but is generally applicable to form other shapes of a non-flat device. Other examples than the ones disclosed above, such as for instance semi-spherical, cylindrical, conical or a shape of a developable surface are equally possible within the scope of the inventive concept, as defined by the appended claims. The first portion 231 of the carrier layer 230 may extend along the periphery of the device region 260 of the flat device laminate 200 in a rectangular or ellipsoidal shape, or any other polygonal shape, depending on the predetermined shape of the non-flat device 100. The second portion 232 of the carrier layer 230 in the non-flat device 100 may protrude from the first portion 231 in a rounded or bent manner, following the shape of the non-flat device 100.

As illustrated in Fig. 2, the flat device laminate 200 may comprise a plurality of device regions 260 and the carrier layer 230 may comprise a plurality of first portions 231 and a plurality of second portions 232, wherein each first portion 231 is arranged to extend along a periphery of a respective device region 260 and each second portion 232 protrudes from a respective first portion 231 into a respective device region 260 to define a free end. In the following, the method will be described in relation to forming a non-flat device 100 from a flat device laminate 200 comprising a plurality of device regions.

The method as illustrated in Fig. 1 comprises a step of deforming S20 by thermoforming S22 the plurality of device regions 260 of the flat device laminate 200 into the shape-retaining non-flat device 100.

The step of deforming S20 by thermoforming S22 may comprise heating the flat device laminate to a temperature above the glass transition temperature of the thermoformable material 210, 220.

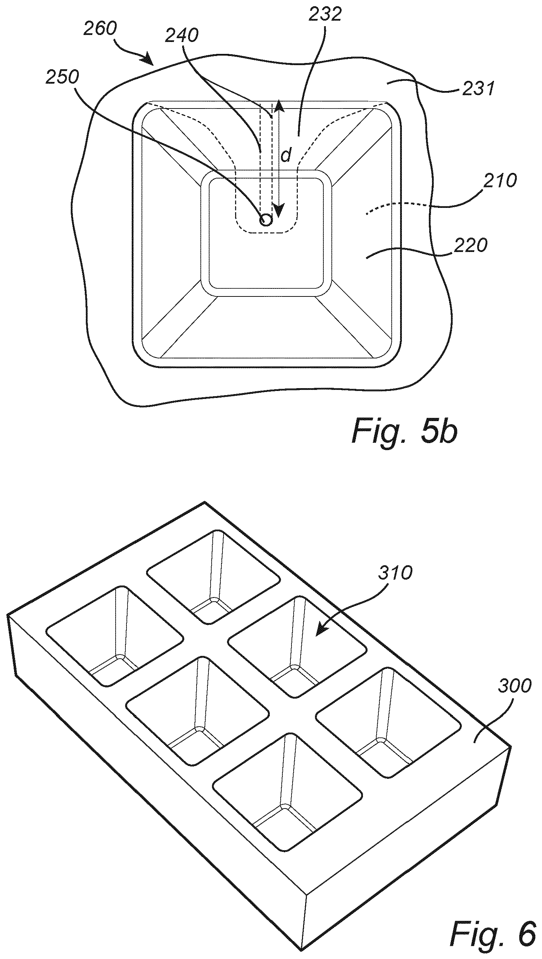

The step of deforming S20 the flat device laminate 200 may further comprise aligning S21 the plurality of device regions 260 of the flat device laminate 200 with a mold 300 comprising a plurality of openings 310 such that each second portion 232 is positioned over an opening 310 in the mold 300 and each first portion 231 extends along a periphery of respective opening of the mold 310. The mold 310 is illustrated in Fig. 6 and may be provided with a shape corresponding to a predetermined shape of the non-flat device 100.

The flat device laminate 200 may be pushed into the mold, e.g. to be pressed against the interior walls of the mold, e.g. using vacuum and cooling. During the step of thermoforming S22, the thermoformable material 210, 220 is stretched while the carrier layer 230, due to its non-stretchable properties, is deformed by bending to follow the shape of the mold 300 without being elongated or shortened. Owning to the adherence of the conductive traces 240 to the carrier layer 230, the length and shape of the conductive traces 240 may remain unchanged after the step of thermoforming S22. As illustrated in Fig.2 and Fig. 5a-b, the respective shortest distance d, along a surface of the second portion 232 of the carrier layer 230, between the circuit element 250 and the first portion 231, prior to and after the step of deforming S20 the flat device laminate 200, are equal.

The second portion 232 of each device region 260 may extend past a centerline of respective opening of the mold 310 by a distance such that the free end of each second portion 232 is positioned at a bottom of the mold 300 after the step of deforming S20.

The method may further comprise, after the step of deforming S20, cutting away non device regions of the flat device laminate 200.

Each of the device regions 260 may be deformed simultaneously or separately.

It should be realized that although the illustrated embodiment comprises a plurality of device regions 260, the flat device laminate 200 and the non-flat device 100 may alternatively comprise only a single device region 260, corresponding to e.g. the device area 260 which is illustrated in Fig. 5b.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for manufacturing a shape-retaining non-flat device (100), comprising:
providing (S10) a flat device laminate (200) comprising:
a first layer of thermoformable material (210);
a carrier layer (230) having:
a first portion (231) arranged to extend along a periphery of a device region (260) of the flat device laminate (200) in which the shape-retaining non-flat device (100) is to be formed, wherein the first portion (231) defines a frame enclosing an opening in the carrier layer (230); and
a second portion (232) protruding from the first portion (231) into the opening in the device region (260) to define a free end in the device region (260);
conductive traces (240) arranged at least on the second portion (232) of the carrier layer (230); and
a circuit element (250) arranged at the free end of the second portion (232) and electrically connected to the conductive traces (240);
deforming (S20) the device region (260) of the flat device laminate (200) into the shape-retaining non-flat device (100) by thermoforming (S22) the flat device laminate (200), wherein the carrier layer (230) is non-stretchable such that the length and shape of the conductive traces (240) remain unchanged after the step of deforming (S20), and the respective shortest distance (d), along the second portion (232) of the carrier layer (230), between the circuit element (250) and the first portion (231), prior to and after the step of deforming (S20) the flat device laminate (200), are equal.

2. A method according to claim 1, wherein the flat device laminate (200) further comprises a second layer of thermoformable material (220) and wherein the carrier layer (230), the conductive traces (240) and the circuit element (250) are embedded between the first and second layer (210, 220).

3. A method according to any one of the preceding claims, wherein the second portion (232) is adapted to extend along a sidewall of the shape-retaining non-flat device (100) after the thermoforming (S22).

4. A method according to any one of the preceding claims, wherein the first portion (231) extends along an entire periphery of the device region (260) of the flat device laminate (200) to define a frame enclosing the device region (260).

5. A method according any one of the preceding claims, wherein the step of deforming (S20) the flat device laminate (200) comprises aligning (S21) the device region (260) of the flat device laminate (200) with a mold (300) such that the second portion (232) is positioned over an opening (310) in the mold (300) and the first portion (231) extends along a periphery of the opening of the mold (310).

6. A method according to claim 5, wherein the second portion (232) extends past a centerline of the opening of the mold (310) by a distance such that the free end of the second portion (232) is positioned at a bottom of the mold (300) after the step of deforming (S20).

7. A method according to any one of the preceding claims, wherein the non-flat device (100) has a shape of a developable surface, a semi-sphere, a cylinder, a truncated pyramidical or a conical shape.

8. A method according to any one of the preceding claims, wherein the circuit element (250) comprises one or more discrete electrical components electrically connected to the conductive traces (240), and/or one or more electrical components integrally formed with the conductive traces (240).

9. A method according to claim 8, wherein the circuit element (250) comprises a light emitting diode.

10. A method according to any one of the preceding claims, wherein circuit element (250) comprises two or more electrical components interconnected to form a sub-circuit electrically connected to the conductive traces (240).

11. A method according to any one of the preceding claims, wherein
the flat device laminate (200) comprises a plurality of device regions (260) and the carrier layer (230) comprises a plurality of first portions (231) and a plurality of second portions (232), wherein each first portion (231) is arranged to extend along a periphery of a respective device region (260) and each second portion (232) protrudes from a respective first portion (231) into a respective device region (260) to define a free end,
and wherein the step of deforming (S20) comprises deforming (S20) the plurality of device regions (260) of the flat device laminate (200) into a respective shape-retaining non-flat device (100) by thermoforming (S22).

12. A method according to claim 11, wherein each of the device regions (260) are deformed simultaneously.

13. A method according to any one of claims 11 or 12 further comprising, after the step of deforming (S20), cutting away non-device regions of the flat device laminate (200).

## Patentansprüche

1. Verfahren zur Herstellung einer formbeständigen, nicht-flachen Vorrichtung (100), umfassend:
Bereitstellen (S10) eines flachen Vorrichtungslaminats (200), umfassend:
eine erste Schicht aus thermoformbarem Material (210);
eine Trägerschicht (230), die aufweist:
einen ersten Abschnitt (231), der so angeordnet ist, dass er sich entlang eines Umfangs einer Vorrichtungsregion (260) des flachen Vorrichtungslaminats (200), in der die formbeständige, nicht-flache Vorrichtung (100) gebildet werden soll, erstreckt, wobei der erste Abschnitt (231) einen Rahmen definiert, der eine Öffnung in der Trägerschicht (230) umfängt; und
einen zweiten Abschnitt (232), der von dem ersten Abschnitt (231) in die Öffnung in der Vorrichtungsregion (260) hinein vorsteht, um ein freies Ende in der Vorrichtungsregion (260) zu definieren;
Leiterbahnen (240), die mindestens auf dem zweiten Abschnitt (232) der Trägerschicht (230) angeordnet sind; und
ein Schaltungselement (250), das an dem freien Ende des zweiten Abschnitts (232) angeordnet und elektrisch mit den Leiterbahnen (240) verbunden ist;
Verformen (S20) der Vorrichtungsregion (260) des flachen Vorrichtungslaminats (200) zu der formbeständigen nicht-flachen Vorrichtung (100) durch Thermoformen (S22) des flachen Vorrichtungslaminats (200), wobei die Trägerschicht (230) nicht-dehnbar ist, dergestalt, dass die Länge und Form der Leiterbahnen (240) nach dem Schritt des Verformens (S20) unverändert bleiben, und die jeweilige kürzeste Distanz (d) entlang des zweiten Abschnitts (232) der Trägerschicht (230) zwischen dem Schaltungselement (250) und dem ersten Abschnitt (231) vor und nach dem Schritt des Verformens (S20) des flachen Vorrichtungslaminats (200) gleich ist.

2. Verfahren nach Anspruch 1, wobei das flache Vorrichtungslaminat (200) des Weiteren eine zweite Schicht aus wärmeformbarem Material (220) umfasst, und wobei die Trägerschicht (230), die Leiterbahnen (240) und das Schaltungselement (250) zwischen der ersten und der zweiten Schicht (210, 220) eingebettet sind.

3. Verfahren nach einem der vorangehenden Ansprüche, wobei der zweite Abschnitt (232) dafür ausgelegt ist, sich nach dem Thermoformen (S22) entlang einer Seitenwand der formbeständigen nicht-flachen Vorrichtung (100) zu erstrecken.

4. Verfahren nach einem der vorangehenden Ansprüche, wobei sich der erste Abschnitt (231) entlang eines gesamten Umfangs der Vorrichtungsregion (260) des flachen Vorrichtungslaminats (200) erstreckt, um einen Rahmen zu definieren, der die Vorrichtungsregion (260) umfängt.

5. Verfahren nach einem der vorangehenden Ansprüche, wobei der Schritt des Verformens (S20) des flachen Vorrichtungslaminats (200) das Ausrichten (S21) der Vorrichtungsregion (260) des flachen Vorrichtungslaminats (200) auf ein Formwerkzeug (300) umfasst, dergestalt, dass der zweite Abschnitt (232) über einer Öffnung (310) in dem Formwerkzeug (300) positioniert ist und der erste Abschnitt (231) sich entlang eines Umfangs der Öffnung (310) des Formwerkzeugs erstreckt.

6. Verfahren nach Anspruch 5, wobei sich der zweite Abschnitt (232) über eine Mittellinie der Öffnung (310) des Formwerkzeugs um eine solche Distanz hinaus erstreckt, dass das freie Ende des zweiten Abschnitts (232) nach dem Schritt des Verformens (S20) an einem Boden des Formwerkzeugs (300) positioniert ist.

7. Verfahren nach einem der vorangehenden Ansprüche, wobei die nicht-flache Vorrichtung (100) die Form einer abwickelbaren Fläche, einer Halbkugel, eines Zylinders oder eines Pyramidenstumpfes oder eine konische Form hat.

8. Verfahren nach einem der vorangehenden Ansprüche, wobei das Schaltungselement (250) eine oder mehrere diskrete elektrische Komponenten umfasst, die elektrisch mit den Leiterbahnen (240) verbunden sind, und/oder eine oder mehrere elektrische Komponenten umfasst, die integral mit den Leiterbahnen (240) gebildet sind.

9. Verfahren nach Anspruch 8, wobei das Schaltungselement (250) eine Leuchtdiode umfasst.

10. Verfahren nach einem der vorangehenden Ansprüche, wobei das Schaltungselement (250) zwei oder mehr elektrische Komponenten umfasst, die miteinander verbunden sind, um eine Teilschaltung zu bilden, die elektrisch mit den Leiterbahnen (240) verbunden ist.

11. Verfahren nach einem der vorangehenden Ansprüche, wobei
das flache Vorrichtungslaminat (200) mehrere Vorrichtungsregionen (260) umfasst und die Trägerschicht (230) mehrere erste Abschnitte (231) und mehrere zweite Abschnitte (232) umfasst, wobei jeder erste Abschnitt (231) so angeordnet ist, dass er sich entlang eines Umfangs einer jeweiligen Vorrichtungsregion (260) erstreckt und jeder zweite Abschnitt (232) von einem jeweiligen ersten Abschnitt (231) in eine jeweilige Vorrichtungsregion (260) hinein vorsteht, um ein freies Ende zu definieren,
und wobei der Schritt des Verformens (S20) das Verformen (S20) der mehreren Vorrichtungsregionen (260) des flachen Vorrichtungslaminats (200) zu einer jeweiligen formbeständigen nicht-flachen Vorrichtung (100) durch Thermoformen (S22) umfasst.

12. Verfahren nach Anspruch 11, wobei jede der Vorrichtungsregionen (260) gleichzeitig verformt wird.

13. Verfahren nach einem der Ansprüche 11 oder 12, das des Weiteren umfasst, nach dem Schritt des Verformens (S20) Regionen des flachen Vorrichtungslaminats (200) wegzuschneiden, die keine Vorrichtungsregionen sind.

## Revendications

1. Procédé de fabrication d'un dispositif non plat à conservation de forme (100), comprenant :
la fourniture (S10) d'un stratifié d'appareil plat (200) comprenant :
une première couche de matériau thermoformable (210) ;
une couche porteuse (230) ayant
une première partie (231) disposée afin de s'étendre le long d'une périphérie d'une région du dispositif (260) du stratifié d'appareil plat (200) dans laquelle le dispositif non plat à conservation de forme (100) doit être formée, dans lequel la première partie (231) définit un cadre renfermant une ouverture dans la couche porteuse (230) ; et
une deuxième partie (232) dépassant de la première partie (231) dans l'ouverture dans la région de dispositif (260) pour définir une extrémité libre dans la région de dispositif (260) ;
des pistes conductrices (240) disposées au moins sur la deuxième partie (232) de la couche porteuse (230) ; et
un élément de circuit (250) disposé au niveau de l'extrémité libre de la deuxième partie (232) et connecté électriquement aux pistes conductrices (240) ;
la déformation (S20)de la région de dispositif (260) du stratifié d'appareil plat (200) en le dispositif non plat à conservation de forme (100) par thermofusion (S22) du stratifié d'appareil plat (200), dans lequel la couche porteuse (230) est non extensible de sorte que la longueur et la forme des pistes conductrices (240) restent inchangées près l'étape de déformation (S20) et la distance la plus courte respective (d), le long de la deuxième partie (232) de la couche porteuse (230), entre l'élément de circuit (250) et le première partie (231), avant et après l'étape de déformation (S20) du stratifié d'appareil plat (200), sont égales.

2. Procédé selon la revendication 1, dans lequel le stratifié d'appareil plat (200) comprend en outre une deuxième couche de matériau thermoformable (220) et dans lequel la couche porteuse (230), les pistes conductrices (240) et l'élément de circuit (250) sont incorporées entre la première et la deuxième couche (210, 220).

3. Procédé selon une quelconque des revendications précédentes, dans lequel la deuxième partie (232) est adapté pour s'étendre le long d'une paroi latérale du dispositif non plat à conservation de forme (100) après la thermofusion (S22).

4. Procédé selon une quelconque des revendications précédentes, dans lequel la première partie (231) s'étend le long de la totalité d'une périphérie de la région de dispositif (260) du stratifié d'appareil plat (200) pour définir un cadre renfermant la région de dispositif (260).

5. Procédé selon une quelconque des revendications précédentes, dans lequel l'étape de déformation (S20) du stratifié plat de dispositif (200) comprend l'alignement (S21) de la région de dispositif (260) du stratifié de dispositif plat (200) avec un moule (300) de sorte que la deuxième partie (232) est positionnée au-dessus d'une ouverture (310) dans le moule (300) et la première partie (231) s'étend le long d'une périphérie de l'ouverture du moule (310).

6. Procédé selon la revendication 5, dans lequel la deuxième partie (232) s'étend au-delà d'une ligne centrale de l'ouverture du moule (310) d'une distance telle que l'extrémité libre de la deuxième partie (232) soit positionnée au niveau d'une base du moule (300) après l'étape de déformation (S20).

7. Procédé selon une quelconque des revendications précédentes, dans lequel le dispositif non plat (100) a une forme d'une surface développable, une demie-sphère, un cylindre, une forme conique ou pyrimidique tronquée.

8. Procédé selon une quelconque des revendications précédentes, dans lequel l'élément de circuit (250) comprend un ou plusieurs composants électriques discrets connectés électriquement aux pistes conductrices (240) et/ou un ou des composants électriques formés en un seul tenant avec les pistes conductrices (240).

9. Procédé selon la revendication 8, dans lequel l'élément de circuit (250) comprend une diode électroluminescente.

10. Procédé selon une quelconque des revendications précédentes, dans lequel l'élément de circuit (250) comprend deux ou plus composants électriques interconnectés afin de former un sous-circuit connecté électriquement aux pistes conductrices (240).

11. Procédé selon une quelconque des revendications précédentes, dans lequel
le stratifié d'appareil plat (200) comprend une pluralité de régions de dispositif (260) et la couche porteuse (230) comprend une pluralité de premières parties (231) et une pluralité de deuxièmes parties (232), dans lequel chaque première partie (231) est agencée pour s'étendre le long d'une périphérie d'une région de dispositif respective (260) et chaque deuxième partie (232) dépasse d'une première partie respective (231) dans une région de dispositif respective (260) pour définir une extrémité libre,
et dans lequel l'étape de déformation (S20) comprend la déformation (S20) de la pluralité de régions de dispositif (260) du stratifié d'appareil plat (200) dans un dispositif non plat à conservation de forme respectif (100) par thermofusion (S22).

12. Procédé selon la revendication 11, dans lequel chacune des régions de dispositif (260) sont déformées simultanément.

13. Procédé selon une quelconque des revendications 11 ou 12 comprenant en outre, après l'étape de déformation (S20), la découpe de régions sans dispositif du stratifié d'appareil plat (200).
